(19) Europäisches Patentamt
European Patent Office
Office européen des brevets

(11) **EP 4 644 927 A1**

(12) **EUROPEAN PATENT APPLICATION**

(43) Date of publication:
**05.11.2025 Bulletin 2025/45**

(21) Application number: **25170881.4**

(22) Date of filing: **16.04.2025**

(51) International Patent Classification (IPC):
**G01R 31/367** (2019.01)  **G01R 31/3828** (2019.01)
**G01R 31/3842** (2019.01)  **G01R 31/388** (2019.01)
**G01R 31/392** (2019.01)

(52) Cooperative Patent Classification (CPC):
**G01R 31/367; G01R 31/3828; G01R 31/3842;
G01R 31/388; G01R 31/392**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **01.05.2024 JP 2024074330**

(71) Applicant: **Prime Planet Energy & Solutions, Inc.
Chuo-ku, Tokyo 103-0022 (JP)**

(72) Inventors:
• **SAKIYAMA, Yoshitaka
Tokyo, 103-0022 (JP)**
• **HAYASHIDA, Atsushi
Tokyo, 103-0022 (JP)**

(74) Representative: **Kuhnen & Wacker
Patent- und Rechtsanwaltsbüro PartG mbB
Prinz-Ludwig-Straße 40A
85354 Freising (DE)**

(54) **BATTERY FULL CHARGE CAPACITY ESTIMATION METHOD, BATTERY FULL CHARGE CAPACITY ESTIMATION DEVICE, AND FULL CHARGE CAPACITY ESTIMATION PROGRAM**

(57)    In a battery system 100 managed by a control unit 20 (a battery management system), a first estimation portion 46 estimates an estimated value H1, based on a value acquired by an acquisition portion 42 and a capacity deterioration model DM1. The acquisition portion 42 acquires information including a voltage value, a temperature value, and a current value. The capacity deterioration model DM1 is a model related to preset information and a capacity deterioration amount of a battery 1. The estimated value H1 is estimated, for example, when an ignition of an electric vehicle is turned on.

FIG.4

## Description

The present disclosure relates to a battery full charge capacity estimation method, a battery full charge capacity estimation device, and a full charge capacity estimation program.

BACKGROUND

Japanese Laid-open Patent Publication No. 2002-243813 discloses a battery capacity deterioration calculation device including a charged state calculation portion that calculates a change of a charged state in a secondary battery and a battery capacity calculation portion that calculates a deterioration-time capacity battery capacity of the secondary battery. The deterioration-time capacity battery capacity is calculated based on a discharge current integrated value during discharging and a change in a charged state. The change of the charged state is calculated based on a correlation between an open voltage and the charged state and an open voltage during discharging. In this case, the correlation between the open voltage and the charged state does not depend on a deteriorated state of the secondary battery. Therefore, when the correlation is known, the change of the charged state of the secondary battery can be obtained, for example, even without a table of deterioration of an internal resistance of the secondary battery prepared, and thus, the deterioration-time battery capacity can be calculated.

Japanese Laid-open Patent Publication No. 2002-243813 describes that, in order to increase accuracy of calculation of the deterioration-time battery capacity, it is desirable to execute calculation of the deterioration-time battery capacity when the change of the charged state is relatively large. That is, for estimation of a full charge capacity of the battery, the change of the charged state needs to be relatively large.

The present inventor desires to estimate a battery full charge capacity with relatively high accuracy regardless of a degree of a change of a charged state.

SUMMARY

A battery full charge capacity estimation method disclosed herein is a full charge capacity estimation method for a battery managed by a battery management system mounted on an electric vehicle, and includes an acquisition step of acquiring preset information of the battery, and a first estimation step of estimating a full charge capacity of the battery, based on a capacity deterioration model in which a relationship between the preset information of the battery and a capacity deterioration amount of the battery is recorded in advance and the preset information of the battery acquired by the acquisition step.

According to the battery full charge capacity estimation method, a battery full charge capacity can be estimated with relatively high accuracy regardless of a degree of a change of a charged state.

BRIEF DESCRIPTION OF THE DRAWINGS

FIG. 1 is a schematic view illustrating a battery system 100.
FIG. 2 is a graph representing an example of a change of SOC in an electric vehicle on which the battery system 100 is mounted.
FIG. 3 is a flowchart for estimating a full charge capacity of a battery 1 according to a first preferred embodiment.
FIG. 4 is a graph illustrating an example of a capacity deterioration model DM1 representing a relationship between a charging and discharging time and capacity deterioration in a predetermined change amount ∆SOC 1 of the battery 1.
FIG. 5 is a graph representing a relationship between an open circuit voltage OCV and SOC.
FIG. 6 is a table illustrating a sheet S1 representing a relationship between a reliability Re and a weighting coefficient W.
FIG. 7A to FIG. 7G are graphs representing coefficients W1 to W7 with respect to corresponding parameters.
FIG. 8 is a graph illustrating an example of a capacity deterioration model DM2 representing a relationship between a left-standing time and capacity deterioration at a predetermined temperature.
FIG. 9 is a table illustrating a sheet S2 representing a relationship between a reliability Re and a weighting coefficient W according to another embodiment.

DETAILED DESCRIPTION

Preferred embodiments of a technology disclosed herein will be described below with reference to the accompanying drawings. As a matter of course, the preferred embodiments described herein are not intended to be particularly limiting the present disclosure.

The accompanying drawings are schematic and do not necessarily reflect actual members or portions. Members/portions that have the same effect will be denoted by the same sign as appropriate, and the overlapping description will be omitted as appropriate.

<Battery System 100>

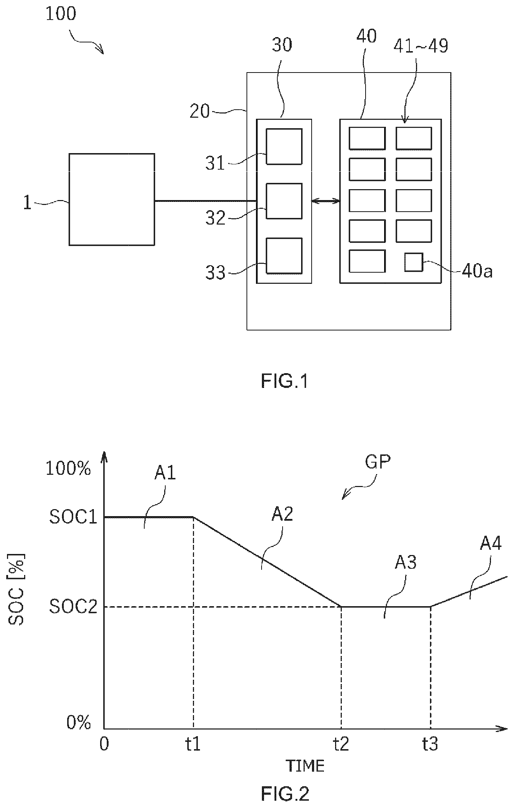

FIG. 1 is a schematic view illustrating a battery system 100. As illustrated in FIG. 1, the battery system 100 includes a battery 1 and a control unit 20. The battery 1 is connected to an unillustrated external load. The control unit 20 manages charging and discharging of the battery 1. That is, the control unit 20 is an example of a battery management system in the present disclosure. The battery system 100 is, for example, an on-vehicle system for a battery electric vehicle (battery EV).

In this specification, the term "battery" refers to electricity storage devices from which electric energy can be taken out. The term "battery" encompasses secondary batteries that can be repeatedly charged and discharged by moving of a charge carrier between a pair of electrodes (a positive electrode and a negative electrode) via an electrolyte and, for example, encompasses lithium-ion secondary batteries. There is no particular limitation on a use form of a battery. The term "battery" encompasses assembled batteries which include multiple secondary batteries (battery cells) electrically connected mutually. In this preferred embodiment, a battery is, for example, a so-called on-vehicle battery that serves as a power source of an electric vehicle. When a battery is used as an on-vehicle battery, the battery is connected to a charge and discharge device, as appropriate, and is charged.

A full charge capacity of the battery 1 reduces over time as the battery 1 is charged and discharged. The full charge capacity is a battery capacity until the battery 1 that has been charged such that a state of charge (SOC) that is a maximum charge capacity is 100% is completely discharged.

The control unit 20 includes a sensor 30 and a control device 40. The sensor 30 includes a voltage sensor 31, a temperature sensor 32, and a current sensor 33. The control device 40 includes a storage portion 41, an acquisition portion 42, a charging and discharging time measurement portion 43, a charging and discharging time acquisition portion 44, a calculation portion 45, a first estimation portion 46, a second estimation portion 47, a weighted averaging portion 48, and a coefficient determination portion 49. For example, the control device 40 can be a computer, such as an electronic control unit (ECU), a microcomputer mounted circuit board, or the like. The computer performs, for example, a desired function in accordance with a preset program. Each function of the computer is processed by cooperation of an arithmetic device (which will be also referred to as a processor, a central processing unit (CPU)), or a micro-processing unit (MPU), a storage device (memory, hard disk, or the like) of a computer, and a software. In this preferred embodiment, the control device 40 is realized by an ECU. A full charge capacity estimation program 40a is installed in the control device 40. The full charge capacity estimation program 40a is a program configured to realize each of the portions 41 to 49 of the control device 40. The control device 40 is configured to be communicable with the sensor 30.

Although not illustrated, the control device 40 may be realized by cooperation of multiple control devices. For example, when the control device 40 is connected to an external computer via a LAN cable, the Internet, or the like such that data communication between the control device 40 and the external computer is enabled, processing of the control device 40 may be performed by cooperation with the external computer as described above. For example, information stored in the control device 40 or a part of the information may be stored in the external computer, and processing that is executed by the control device 40 or a part of the processing may be executed by the external computer.

FIG. 2 is a graph GP illustrating an example of a change of SOC in an electric vehicle on which the battery system 100 is mounted. An abscissa of the graph GP represents a time, and an ordinate of the graph GP represents SOC of the battery 1. In the graph GP, an area sectioned by a time 0 to a time t1 is an area A1. Similarly, in the graph GP, an area sectioned by a time t1 to a time t2, an area sectioned by a time t2 to a time t3, and an area at and after a time t3 are areas A2, A3, and A4, respectively. The area A1 is an area in which an ignition of the electric vehicle on which the battery system 100 is mounted (which will be hereinafter simply referred to as "an ignition") is off and SOC is SOC1. The area A2 is an area in which the ignition is on after the area A1. For example, during a time corresponding to the area A2, the electric vehicle travels. However, SOC may increase while the electric vehicle travels. When the electric vehicle travels, the battery 1 (see FIG. 1) is discharged, and SOC decreases. The area A3 is an area in which the ignition is off and SOC is SOC2. SOC2 is SOC that is lower than SOC1. The area A4 is an area in which the ignition is on during a time following the area A3.

The voltage sensor 31 of the sensor 30 illustrated in FIG. 1 is a sensor that detects a voltage value of the battery 1. For example, the voltage sensor 31 detects the detected voltage value of the battery 1 as an analog signal. Note that the voltage that is detected by the voltage sensor 31 is a close circuit voltage CCV. The detected analog signal is converted to a digital signal by an A/D converter (not illustrated) and is output to the acquisition portion 42 of the control device 40 (see FIG. 1) that will be described later. Similar to the voltage sensor 31, the temperature sensor 32 and the current sensor 33 of the sensor 30 detect a temperature of the battery 1 and a current value of the battery 1, respectively. The temperature and the current value that have been detected are transmitted to the acquisition portion 42 that will be described later. The sensor 30 detects each value in each of a state where the ignition is on and a state where the ignition is on. Each of the voltage sensor 31, the temperature sensor 32, and the current sensor 33 detects a corresponding one of the voltage value, the temperature value, and the current value at a preset interval. Although there is no particular limitation on the interval at which each of the voltage sensor 31, the temperature sensor 32, and the current sensor 33 executes detection, the interval is, for example, about 0.001 to 1 seconds.

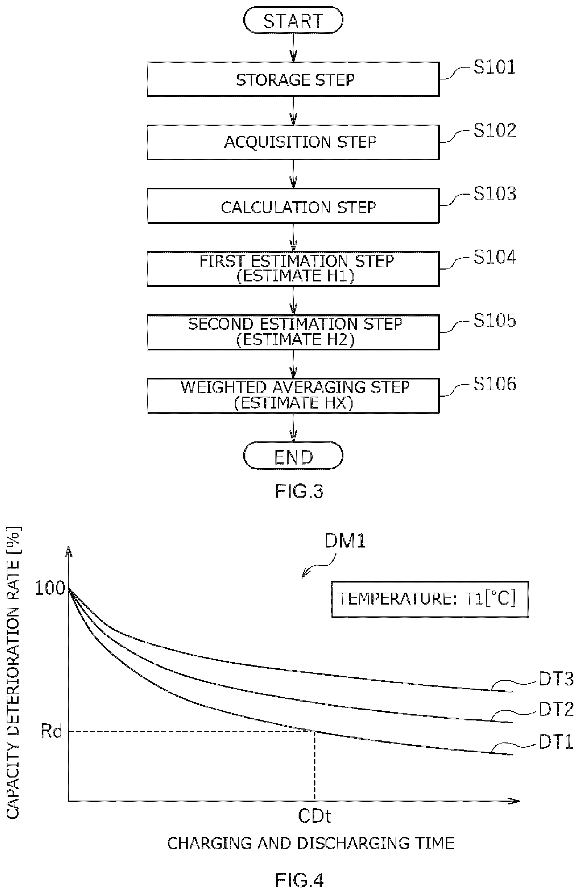

A method for estimating the full charge capacity of the battery 1 by the control unit 20 will be described below along with a configuration of the control unit 20. FIG. 3 is a flowchart for estimating the full charge capacity of the battery 1 according to a first preferred embodiment. A flow illustrated in FIG. 3 is performed at the time t3 (when the ignition is turned on at a boundary between the area A3 and the area A4) illustrated in FIG. 2, except a storage step S101. However, a timing at which the flow starts is not limited thereto.

The storage step S101 illustrated in FIG. 3 is a step of storing a capacity deterioration model related to preset information of the battery 1 and a capacity deterioration amount of the battery 1. The storage step S101 can be realized by the storage portion 41 of the control device 40 (see FIG. 1). In this preferred embodiment, the storage portion 41 stores a capacity deterioration model DM1 (see FIG. 4). The capacity deterioration model DM1 is acquired by test, simulation, theoretical calculation, or the like in advance, and is stored. For example, for the capacity deterioration model DM1, each data is acquired when the battery system 100 (see FIG. 1) is manufactured.

FIG. 4 is a graph illustrating an example of the capacity deterioration model DM1 representing a relationship between a charging and discharging time and capacity deterioration in a predetermined change amount $\Delta SOC1$ of the battery 1. The change amount $\Delta SOC1$ is a change amount when SOC of the battery 1 changes. As described above, the capacity deterioration model DM1 is a model related to the preset information and the capacity deterioration amount of the battery 1. In this preferred embodiment, as the preset information, a temperature, SOC, the change amount $\Delta SOC1$, and the capacity deterioration amount are included. The temperature and SOC are measured by a known method when the capacity deterioration model DM1 is formed.

In the capacity deterioration model DM1, the change amount $\Delta SOC1$ is obtained by dividing a current integrated amount by the full charge capacity. Therefore, the preset information includes the current integrated amount and the full charge capacity at acquisition of each data. The current integrated amount and the full charge capacity at acquisition of each data are acquired by a known method.

An abscissa of the capacity deterioration model DM1 represents a charging and discharging time. An ordinate of the capacity deterioration model DM1 represents a capacity deterioration rate. The capacity deterioration rate is a ratio of the full charge capacity at acquisition of each data when the full charge capacity of the battery 1 at a time when the charging and discharging time is 0 is 100%.

The capacity deterioration model DM1 includes data DT1, date DT2, and data DT3. In this preferred embodiment, the data DT1 is test data when charging and discharging is performed with the change amount $\Delta SOC1 = 80\%$ in the battery 1. The data DT2 is test data when charging and discharging is performed with the change amount $\Delta SOC1 = 50\%$. The data DT3 is test data when charging and discharging is performed with the change amount $\Delta SOC1 = 20\%$. However, a numerical value of the change amount $\Delta SOC1$ in the capacity deterioration model DM1 is not limited thereto. A number of pieces of data included in the capacity deterioration model DM1 is not limited to three.

As illustrated in FIG. 4, the capacity deterioration model DM1 is data in a state where the temperature of the battery 1 is a temperature T1 °C. That is, each of the data DT1, the data DT2, and the data DT3 is data acquired such that the temperature of the battery 1 when the capacity deterioration rate is acquired is T1 °C. Although illustration is omitted, multiple capacity deterioration models generated based on data acquired where the temperature of the battery 1 at acquisition of the capacity deterioration rate is a temperature other than the temperature T1 °C are stored in the storage portion 41. Alternatively, the capacity deterioration models in a case where the temperature of the battery 1 is a temperature other than the temperature T1 °C may be obtained by correcting the capacity deterioration model DM1 in accordance with a preset ratio for the temperature of the battery 1.

An acquisition step S102 illustrated in FIG. 3 is a step of acquiring the preset information of the battery 1. The acquisition step S102 can be realized by the acquisition portion 42 of the control device 40 (see FIG. 1). The acquisition portion 42 acquires information including the voltage value, the current value, and the temperature value acquired by the sensor 30 (see FIG. 1). As described above, the sensor 30 detects each value with a preset time interval and transmits the detected value. In this preferred embodiment, a charging and discharging time CDt is acquired by the charging and discharging time measurement portion 43 (see FIG. 1) of the control device 40. The charging and discharging time measurement portion 43 measures a time during which charging or discharging is performed in the battery system 100. In this preferred embodiment, as illustrated in FIG. 2, the battery 1 is discharged during a time from the time t1 to the time t2. Therefore, the charging and discharging time measurement portion 43 measures a time (t2 - t1) that is the time from the time t1 to the time t2. In this preferred embodiment, the time from the time t1 to the time t2 is the charging and discharging time CDt. The charging and discharging time measurement portion 43 transmits the charging and discharging time CDt to the acquisition portion 42 (see FIG. 1), and the acquisition portion 42 acquires the charging and discharging time CDt. In this preferred embodiment, an initial full charge capacity Ho of the battery 1 is acquired. For example, the full charge capacity Ho may be stored in the control device 40 in advance.

A calculation step S103 illustrated in FIG. 3 is a step of calculating a change amount ΔSOC2 of SOC of the battery 1, based on the information of the battery 1 acquired by the acquisition portion 42 in the acquisition step S102. The change amount ΔSOC2 is a change amount of SOC before and after the ignition is in an on state. The calculation step S103 can be realized by the calculation portion 45. In this preferred embodiment, the calculation portion 45 calculates the change amount of SOC during the time from the time t1 to the time t2 (the area A2) illustrated in FIG. 2 as the change amount ΔSOC2. The calculation portion 45 first acquires the voltage value at the time t1 among the voltage values acquired by the acquisition portion 42. In this preferred embodiment, a state where the ignition is off continues before the time t1, and therefore, the voltage at the time t1 can be considered as an open circuit voltage OCV. The voltage value at the time t1 is a voltage V1. The acquisition portion 42 acquires the voltage value at the time t3. The state where the ignition is off continues during the time from the time t2 to the time t3, and therefore, the voltage value at the time t3 can be considered as the open circuit voltage OCV. The voltage value at the time t3 is a voltage V2. Note that, when the voltage value detected by the voltage sensor 31 is the close circuit voltage, the open circuit voltage may be estimated using the close circuit voltage and a known voltage behavior model.

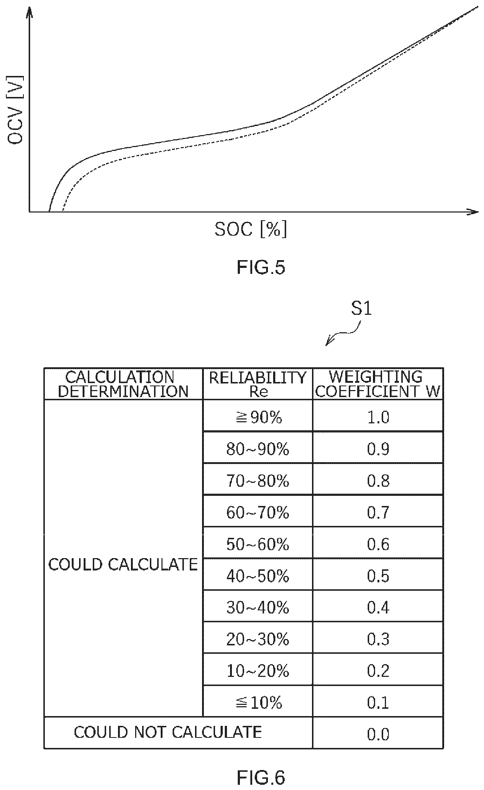

SOC1 and SOC2 of the battery 1 (see FIG. 2) are estimated based on the voltages V1 and V2. SOC1 is SOC of the battery 1 at the time t1. SOC2 is SOC of the battery 1 at the time t3. In this preferred embodiment, SOC1 and SOC2 of the battery 1 are estimated using an OCV-SOC conversion table (see FIG. 5) stored in the control device 40 in advance. The OCV-SOC conversion table may be acquired in advance by test, simulation, theoretical calculation, or the like and be stored in the control device 40.

FIG. 5 is a graph representing a relationship between an open circuit voltage OCV and SOC. In FIG. 5, the relationship between the open circuit voltage OCV and SOC is represented by a graph. Note that, in FIG. 5, the relationship between the open circuit voltage OCV and SOC is schematically indicated, and does not necessarily reflect an actual relationship. In FIG. 5, the open circuit voltage OCV after charging is indicated by a solid line, and the open circuit voltage OCV after discharging is indicated by a broken line. As illustrated in FIG. 5, in the OCV-SOC conversion table, the open circuit voltage OCV is recorded in association with SOC. In the OCV-SOC conversion table illustrated in FIG. 5, a relationship between the open circuit voltage OCV after charging and SOC and a relationship between the open circuit voltage OCV after discharging and SOC are different from each other. Depending on whether the acquired current value is a current value acquired during charging or a current value acquired during discharging, the relationship between the open circuit voltage OCV and SOC that is used for estimation of SOC may be selected as appropriate. Note that estimation of SOC of the battery 1 is not limited thereto and a known method, such as an IV method for obtaining the open circuit voltage from plots of the current value and CCV or the like, may be used therefor. A method for estimating SOC may be determined in accordance with a use form of the battery 1 or the like. When SOC1 and SOC2 are estimated from the voltage V1, the voltage V2, and the OCV-SOC conversion table, the calculation portion 45 calculates the change amount ΔSOC2. The change amount ΔSOC2 is calculated as a difference between SOC1 and SOC2.

A first estimation step S104 illustrated in FIG. 3 is a step of estimating the full charge capacity of the battery 1, based on the capacity deterioration model DM1 in which the relationship between the preset information of the battery 1 and the capacity deterioration amount of the battery 1 is recorded in advance and the preset information of the battery 1 acquired by the acquisition step S102. The first estimation step S104 can be realized by the first estimation portion 46 (see FIG. 1). In this preferred embodiment, the full charge capacity of the battery 1 is estimated further using, in addition to information acquired by the acquisition portion 42, the charging and discharging time CDt measured by the charging and discharging time measurement portion 43 (see FIG. 1) and the initial full charge capacity Ho of the battery 1. The first estimation portion 46 selects ΔSOC that matches with the change amount ΔSOC1 among ΔSOCs of the data DT1 to the data DT3 of the capacity deterioration model DM1 illustrated in FIG. 4. For example, when it is assumed that the change amount ΔSOC1 is 80%, the change amount ΔSOC1 matches with ΔSOC in the data DT1. At this time, the first estimation portion 46 acquires the capacity deterioration rate to a value of the charging and discharging time CDt acquired by the acquisition portion 42 from the data DT1. As illustrated in FIG. 4, in the data DT1, a capacity deterioration rate Rd corresponds to the value of charging and discharging time CDt. The first estimation portion 46 estimates the full charge capacity of the battery 1 by multiplying the initial full charge capacity Ho of the battery 1 by the capacity deterioration rate Rd. The full charge capacity estimated by the first estimation portion 46 is an estimated value H1. Note that ΔSOC that is closest to the change amount ΔSOC1 among the respective ΔSOCs of the data DT1 to the data DT3 may be selected.

A second estimation step S105 illustrated in FIG. 3 is a step of estimating the full charge capacity of the battery 1, based on a discharge current integrated value ΣA1 that is an integrated value of a discharge current of the battery 1 and the change amount ΔSOC2 of SOC of the battery 1. The second estimation step S105 can be realized by the second estimation portion 47 (see FIG. 1). In this preferred embodiment, the second estimation portion 47 acquires an estimated value H2 of the full charge capacity of the battery 1, based on Equation 1 as follows:

[Equation 1]

$$H2 = (\Sigma A1 / \Delta SOC2) \times 100.$$

Herein, the discharge current integrated value $\Sigma A1$ is a value obtained by integrating a current value in the time from the time t1 to the time t2 among current values acquired by the current sensor 33 (see FIG. 1). In performing calculation based on Equation 1, the discharge current integrated value $\Sigma A1$ is also calculated by the second estimation portion 47.

A weighted averaging step S106 is a step of estimating the full charge capacity of the battery 1 by adding a result obtained by multiplying the estimated value H1 of the full charge capacity of the battery 1 estimated by the first estimation step S104 by a preset weighting coefficient and a result obtained by multiplying the full charge capacity of the battery 1 estimated by the second estimation step S 105 by a preset weighting coefficient and averaging a result of adding. The weighted averaging step S106 can be realized by the weighted averaging portion 48 (see FIG. 1). In this preferred embodiment, the weighted averaging portion 48 performs calculation using the estimated values H1 and H2 and a weighting coefficient W. Details of the weighting coefficient W will be described later. When it is assumed that an estimated value of the full charge capacity calculated by the weighted averaging portion 48 is Hx, the weighted averaging portion 48 calculates an estimated value Hx, based on Equation 2 as follows:

[Equation 2]

$$Hx = H1 \times (1 - W) + H2 \times W.$$

Note that, although, in this preferred embodiment, the estimated value H2 is multiplied by the weighting coefficient W and the estimated value H1 is multiplied by (1 - W), the technology disclosed herein is not limited thereto. The estimated value H1 may be multiplied by the weighting coefficient W. Thus, the estimated value Hx is calculated.

The weighting coefficient W is obtained by a reliability Re illustrated in FIG. 6. FIG. 6 is a table illustrating a sheet S1 representing a relationship between the reliability Re and the weighting coefficient W. The reliability Re is an index indicating how reliable the estimated value H2 is. As illustrated in FIG. 6, a value of the weighting coefficient W is associated with a range of a numerical value of the reliability Re. For example, the sheet S1 is stored in the control device 40 in advance.

Now, the reliability Re will be described. The reliability Re is calculated based on Equation 3 as follows:

[Equation 3]

$$Re = (W1 \times W2 \times W3 \times W4 \times W5 \times W6 \times W7) \times 100.$$

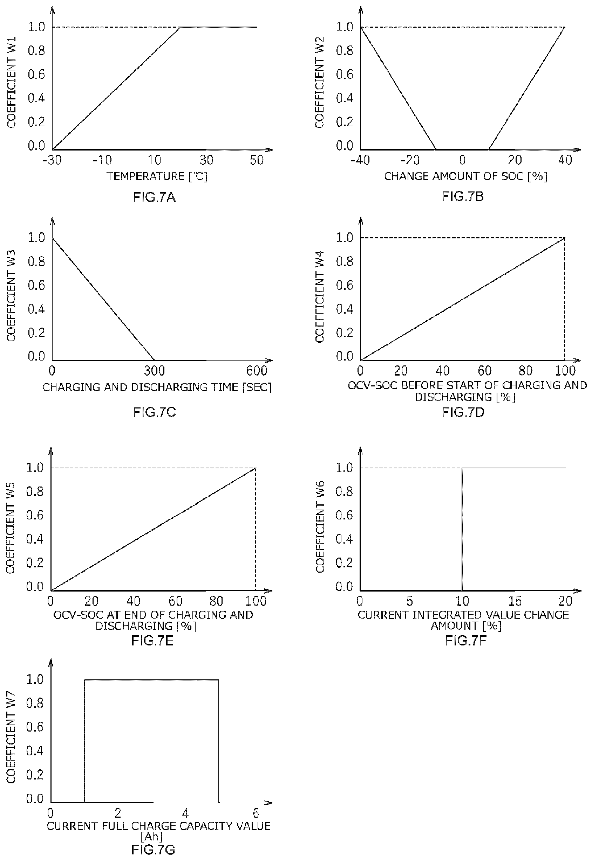

Each of coefficients W1 to W7 is set to 0 or more and 1 or less. Each of coefficients W1 to W7 is determined by the coefficient determination portion 49 (see FIG. 1) of the control device 40. Each of coefficients W1 to W7 is a value of 0 or more and 1 or less, and therefore, the reliability Re can be a numerical value of 0% or more and 100% or less. However, the reliability Re is not limited to a value expressed in terms of percentage. The reliability Re may represent, for example, a ratio by a numerical value of 0 or more and 1 or less. As illustrated in FIG. 6, in this preferred embodiment, the weighting coefficient W is associated with every 10% for the numerical value of the reliability Re. A value that each of the coefficients W1 to W7 can be is allocated to a corresponding one of the coefficients W1 to W7 in accordance with a value of a corresponding parameter. FIG. 7A to FIG. 7G are graphs representing the coefficients W1 to W7 with respect to corresponding parameters. Note that the graphs illustrated in FIG. 7A to FIG. 7G are merely examples, and numerical values of the coefficients W1 to W7 are not limited thereto. Each of the coefficients W1 to W7 may be set such that the coefficients corresponding to values of the parameters are indicated in a form of a table. Each of the coefficients W1 to W7 will be described below.

FIG. 7A is a graph illustrating a relationship between the temperature of the battery 1 and the coefficient W1. Herein, the temperature of the battery 1 is the temperature of the battery 1 at estimation of the full charge capacity. In this preferred embodiment, the temperature of the battery 1 is the temperature of the battery 1 at the time t3 (see FIG. 2). The temperature of the battery 1 is detected by the temperature sensor 32 (see FIG. 1) and is acquired by the acquisition portion 42 (see FIG. 1). As illustrated in FIG. 7A, a value of the coefficient W1 increases in proportion to the temperature of the battery 1. In this preferred embodiment, when the temperature of the battery 1 is 20 °C or more, the value of the coefficient W1 is constantly 1. The coefficient determination portion 49 (see FIG. 1) determines the value of the coefficient W1 from the temperature of the battery 1 acquired by the acquisition portion 42 and the graph of FIG. 7A.

FIG. 7B is a graph illustrating a relationship between the change amount of SOC and the coefficient W2. Herein, the change amount of SOC in FIG. 7B is synonymous with the change amount $\Delta SOC2$ calculated by the calculation portion 45 (see FIG. 1) in the calculation step S103 (see FIG. 3). In this preferred embodiment, as illustrated in FIG. 7B, the larger an absolute value of the change amount of SOC is, the larger a value of the coefficient W2 becomes. More specifically, when the change amount of SOC is smaller than -10%, as the change amount of SOC increases, the coefficient W2 increases. When the change amount of SOC is larger than 10%, as the change amount of SOC increases, the coefficient W2 increases. When the change amount of SOC is -40% or less or the change amount is 40% or more, the value of the coefficient W2 is constantly 1. When the change amount of SOC is -10% or more and 10% or less, the value of the coefficient W2 is 0. The coefficient determination portion 49 (see FIG. 1) determines the value of the coefficient W2 from the value of the change amount ΔSOC2 calculated by the calculation portion 45 and the graph of FIG. 7B. Note that a shape of the graph illustrated in FIG. 7B is not limited thereto. The relationship between the change amount of SOC and the coefficient W2 may be, for example, a relationship in which, as the value of the change amount of SOC decreases, the value of the coefficient W2 increases.

FIG. 7C is a graph illustrating a relationship between a charging and discharging time and the coefficient W3. As illustrated in FIG. 7C, as the charging and discharging time increases, the coefficient W3 decreases. When the charging and discharging time is 300 sec or more, the value of the coefficient W3 is constantly 0. In this preferred embodiment, the charging and discharging time CDt is measured by the charging and discharging time measurement portion 43 (see FIG. 1). The charging and discharging time CDt is acquired by the acquisition portion 42 in the acquisition step S102. The coefficient determination portion 49 (see FIG. 1) determines the coefficient W3 from the charging and discharging time CDt acquired by the acquisition portion 42 and the graph of FIG. 7C.

FIG. 7D is a graph illustrating a relationship between OCV-SOC before charging and discharging is started and the coefficient W4. OCV-SOC before charging and discharging is started is SOC estimated based on OCV acquired before charging and discharging of the battery 1 is started. In this preferred embodiment, OCV acquired before charging and discharging is started is OCV at the time t1 (see FIG. 2). SOC estimated from OCV at the time t1 is SOC1 (see FIG. 2). OCV-SOC at the time t1 is acquired by the calculation portion 45 in the calculation step S103. As illustrated in FIG. 7D, in this preferred embodiment, as OCV-SOC at the time t1 increases, the coefficient W4 increases. The coefficient determination portion 49 (see FIG. 1) determines the coefficient W4 from OCV-SOC (SOC1) before charging and discharging is started and the graph of FIG. 7D.

FIG. 7E is a graph illustrating a relationship between OCV-SOC when charging and discharging ends and the coefficient W5. OCV-SOC when charging and discharging ends is SOC estimated based on OCV acquired when charging and discharging of the battery 1 ends. In this preferred embodiment, OCV acquired when charging and discharging of the battery 1 ends is OCV at the time t2 (see FIG. 2). SOC estimated based on OCV at the time t2 is SOC2 (see FIG. 2). OCV-SOC at the time t2 is acquired by the calculation portion 45 in the calculation step S103. As illustrated in FIG. 7E, in this preferred embodiment, as OCV-SOC when charging and discharging at the time t2 increases, the coefficient W5 increases. The coefficient determination portion 49 (see FIG. 1) determines the coefficient W5 from the OCV-SOC (SOC2) when charging and discharging ends and the graph of FIG. 7E.

FIG. 7F is a graph illustrating a relationship between a current integrated value change amount and the coefficient W6. The current integrated value change amount is a change amount of the integrated current value when the battery 1 has performed charging and discharging. In this preferred embodiment, the current integrated value change amount is represented by a ratio to the discharge current integrated value when the battery 1 is fully charged (SOC 100%). The discharge current integrated value when the battery 1 is fully charged is stored in the control device 40 in advance. In this preferred embodiment, the discharge current integrated value ΣA1 when the battery 1 has performed charging and discharging is calculated in the second estimation step S105. As illustrated in FIG. 7F, in this preferred embodiment, when the current integrated value change amount is less than 10%, a value of the coefficient W6 is 0, and when the current integrated change amount is 10% or more, the value of coefficient W6 is 1. The coefficient determination portion 49 (see FIG. 1) determines the coefficient W6 from the discharge current integrated value ΣA1 calculated in the second estimation Step S105, the discharge current integrated value when the battery 1 is fully charged, and the graph of FIG. 7F.

FIG. 7G is a graph illustrating a relationship between a current full charge capacity value and the coefficient W7. Herein, the current full charge capacity value is the estimated value H2 estimated by the second estimation portion 47. As illustrated in FIG. 7G, in this preferred embodiment, when the estimated value H2 is 1 or more and 5 or less, a value of the coefficient W7 is 1. When the estimated value H2 is 1 or less or is more than 5, the value of the coefficient W7 is 0. The coefficient determination portion 49 (see FIG. 1) determines the coefficient W7 from the estimated value H2 estimated by the second estimation portion 47 and the graph of FIG. 7G.

The weighted averaging portion 48 (see FIG. 1) calculates the reliability Re, based on Equation 3. The coefficients W1 to W7 in Equation 3 are determined by the coefficient determination portion 49, as described above. The weighted averaging portion 48 refers to the weighting coefficient W that corresponds to the calculated reliability Re from the sheet S1 (see FIG. 6) and acquires the weighting coefficient W. When the weighting coefficient W is acquired, the weighted averaging portion 48 calculates the estimated value Hx of the full charge capacity, based on Equation 2. Note that, when the reliability Re could not be calculated, for example, when a numerical value necessary for calculating the reliability Re could not be acquired due to a failure of the sensor 30 (see FIG. 1), the weighting coefficient W is set to 0. At this time, based on Equation 2, the estimated value H2 is not used for calculation of the estimated value Hx and the estimated value H1 and the estimated value Hx are equal.

Incidentally, in a case where battery full charge capacity estimation is executed, when a change amount of the charged state is relatively small, an error of detection of a voltage value or the like is relatively large with respect to a value of the change amount of the charged state. In this case, accuracy of an estimated value of the battery full charge capacity that is obtained using the change amount of the charged state is relatively low. Therefore, by executing full charge capacity estimation only when the change amount of the charged state is relatively large, an estimation result with relatively high accuracy can be obtained. However, according to the fining of the present inventor, a change amount of the charged state at a level at which full charge capacity estimation is not executed can continue for a relatively long period. For example, a case where a time during which an electric vehicle on which the battery is mounted is driven is relatively short applies to this case. In this case, full charge capacity estimation is not executed for a relatively long period, and therefore, there is a probability that a deviation between a full charge capacity of the battery estimated last and an actual full charge capacity of the battery arises.

According to the full charge capacity estimation method for the battery 1 according to this preferred embodiment, in the battery system 100 managed by the control unit 20 (battery management system), the first estimation portion 46 estimates the estimated value H1, based on the value acquired by the acquisition portion 42 and the capacity deterioration model DM1. The capacity deterioration model DM1 is a model that is recorded in advance for the capacity deterioration amount of the battery 1. Therefore, the estimated value H1 can be acquired regardless of the magnitude of the change amount $\Delta SOC1$. In this preferred embodiment, estimation by the first estimation portion 46 is executed at the time t3, that is, when the ignition of the electric vehicle on which the battery system 100 is mounted is turned on. Accordingly, estimation by the first estimation portion 46 is executed relatively often. Therefore, it is suppressed that estimation of full charge capacity is not executed for a relatively long time. Thus, it is suppressed that a deviation between the estimated value H1 and the actual full charge capacity of the battery 1 arises.

According to the full charge capacity estimation method for the battery 1 of this preferred embodiment, in the second estimation step S105, the second estimation portion 47 estimates the full charge capacity. The estimated value H2 of the full charge capacity is calculated based on the discharge current integrated value $\Sigma A1$ and the change amount $\Delta SOC2$ in accordance with Equation 1. Thereafter, in the weighted averaging step S106, as expressed in Equation 2, the estimated value H1 and the estimated value H2 are weighted and averaged. Herein, the estimated value H2 is a value obtained by estimating the full charge capacity using the change amount $\Delta SOC2$, and when the change amount $\Delta SOC2$ is relatively small, accuracy of estimation of the estimated value H2 is relatively low. On the other hand, the estimated value H1 is based on the capacity deterioration model DM1, and therefore, accuracy of estimation of the estimated value H1 does not depend on the change amount $\Delta SOC1$. Therefore, the estimated value H1 the estimation accuracy of which does not depend on the magnitude of the change amount $\Delta SOC1$ and the estimated value H2 the estimation accuracy of which depends on the change amount $\Delta SOC2$ are weighted to estimate the estimated value Hx, so that the estimation accurate of the estimated value Hx can be increased to a relatively high level.

According to the full charge capacity estimation method for the battery 1 according to this preferred embodiment, in the weighted averaging step S106, the larger the absolute value of the change amount $\Delta SOC2$ estimated in the second estimation step S105 is, the larger the value of the coefficient W2 becomes. Accordingly, the larger the absolute value of the change amount $\Delta SOC2$ is, the more the estimated value H2 is weighted. The estimated value H2 is an estimated value including a value acquired by the sensor 30. Therefore, the estimated value H2 is a value estimated based on an actual measurement value of information related to the battery 1. Accordingly, when the absolute value of the change amount $\Delta SOC2$ is relatively large, weighting of the estimated value H2 based on the actual measurement value of the battery 1 can be increased. That is, the estimation accuracy of the estimated value Hx can be increased to a relatively high level.

One preferred embodiment described above is merely an example of a battery full charge capacity estimation disclosed herein. The technology disclosed herein can be implemented in various other forms.

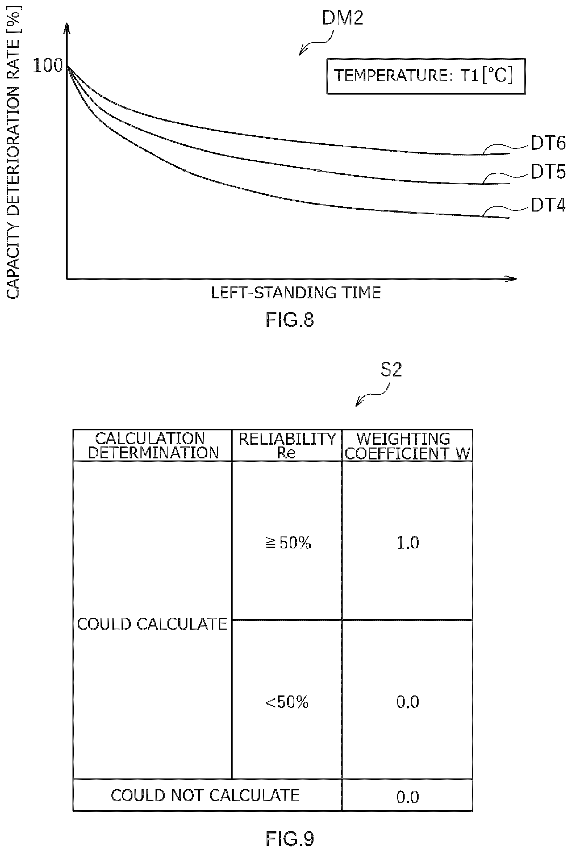

In the preferred embodiment described above, the capacity deterioration model DM1 represents the relationship between the charging and discharging time and capacity deterioration in the predetermined change amount $\Delta SOC1$, but the technology disclosed herein is not limited thereto. FIG. 8 is a graph illustrating an example of a capacity deterioration model DM2 representing a relationship between a left-standing time at a predetermined temperature and capacity deterioration. An ordinate of the capacity deterioration model DM2 is the same as that of the capacity deterioration model DM1 (see FIG. 4). An abscissa of the capacity deterioration model DM2 represents the left-standing time when the battery 1 has been left standing at the predetermined temperature. That is, in the capacity deterioration model DM2, the left-standing time is included as the preset information. The capacity deterioration model DM2 includes data DT4, data DT5, and data DT6. The data DT4, the data DT5, and the data DT6 represent pieces data when the battery 1 was left standing in a state where SOC of the battery 1 is 80%, a state where SOC of the battery 1 is 50%, and a state where SOC of the battery 1 is 20%, respectively. However, a numerical value of SOC in the capacity deterioration model DM2 is not limited thereto. A number of pieces of data included in the capacity deterioration model DM2 is not limited to three. The capacity deterioration model DM2 includes the pieces of data in a state where the temperature of the battery 1 is a temperature T1 °C. Similar to the preferred embodiment described above, a capacity deterioration model in a state where the temperature of the battery 1 is a temperature other than the temperature may be stored in the storage portion 41.

When the capacity deterioration model DM2 is used, for example, the left-standing time is a time during which the battery 1 was left standing is acquired by the acquisition portion 42 (see FIG. 1) without being charged and discharged. The left-standing time is, for example, a time from the time t2 to the time t3 (the area A3) illustrated in FIG. 2. The first estimation portion 46 (see FIG. 1) acquires the capacity deterioration rate using the left-standing time acquired by the acquisition portion 42 and the capacity deterioration model DM2. Note that the capacity deterioration model can be formed by not only the capacity deterioration models DM1 and DM2 but also by various types information related to the battery 1.

In the preferred embodiment described above, in the sheet S1 illustrated in FIG. 6, the weighting coefficient W is associated for every 10% of the numerical value of the reliability Re, but the technology disclosed herein is not limited thereto. FIG. 9 is a table illustrating a sheet S2 representing a relationship between the reliability Re and the weighting coefficient W according to another embodiment. As illustrated in FIG. 9, a sheet in which the weighting coefficient W when the reliability Re is 50% or more is 1 and the weighting coefficient W when the reliability Re is less than 50% is 0 may be employed. That is, based on Equation 2, when the reliability Re is 50% or more, the estimated value Hx and the estimated value H2 may be equal, and when the reliability Re is less than 50%, the estimated value Hx and the estimated value H1 may be equal.

A full charge capacity estimation program 40a of this preferred embodiment may be stored, for example, in a non-transitory computer readable medium. The program can be supplied to a computer via the non-transitory computer readable medium. Note that examples of the non-transitory computer readable medium include a magnetic recording medium (for example, a flexible disk, a magnetic tape, or a hard disk drive), a read only memory (CD-ROM), or the like.

As described above, the present specification includes disclosure set force in the following items.

First Item: A battery full charge capacity estimation method for a battery managed by a battery management system mounted on an electric vehicle, the battery full charge capacity estimation method including an acquisition step of acquiring preset information of the battery, and a first estimation step of estimating a full charge capacity of the battery, based on a capacity deterioration model in which a relationship between the preset information of the battery and a capacity deterioration amount of the battery is recorded in advance and the preset information of the battery acquired by the acquisition step.

Second Item: The battery full charge capacity estimation method according to the first item, further including a second estimation step of estimating the full charge capacity of the battery, based on a discharge current integrated value that is an integrated value of a discharge current of the battery and a change amount of SOC of the battery, and a weighted averaging step of estimating the full charge capacity of the battery by adding a result obtained by multiplying the full charge capacity of the battery estimated by the first estimation step by a preset weighting coefficient and a result obtained by multiplying the full charge capacity of the battery estimated by the second estimation step by a preset weighting coefficient and averaging a result of adding.

Third Item: The battery full charge capacity estimation method according to the second item, in which, in the weighted averaging step, a weight of the weighting coefficient of the estimated value estimated by the second estimation step is increased as an absolute value of the change amount of SOC of the battery in the second estimation step increases.

Fourth Item: A battery full charge capacity estimation device for a battery managed by a battery management system mounted on an electric vehicle, the battery full charge capacity estimation device including a sensor, and a control device, in which the sensor includes a voltage sensor, a temperature sensor, and a current sensor, and the control device includes a storage portion that stores a capacity deterioration model related to preset information of the battery and a capacity deterioration amount of the battery, an acquisition portion that acquires information including a voltage value, a current value, a temperature value of the battery acquired by the sensors, and a first estimation portion that estimates a full charge capacity of the battery, based on the information acquired by the acquisition portion and the capacity deterioration model.

Fifth Item: The battery full charge capacity estimation device according to the fourth item, in which the control device further includes a second estimation portion that estimates the full charge capacity of the battery, based on a discharge current integrated value that is an integrated value of a discharge current of the battery and a change amount of SOC of the battery, and a weighted averaging portion that estimates the full charge capacity of the battery by adding a result obtained by multiplying the full charge capacity of the battery estimated by the first estimation portion by a preset weighting coefficient and a result obtained by multiplying the full charge capacity of the battery estimated by the second estimation portion by a preset weighting coefficient and averaging a result of adding.

Sixth Item: The battery full charge capacity estimation device according to the fifth item, in which the weighted averaging portion increases a weight of the weighting coefficient of the estimated value estimated by the second estimation portion as an absolute value of the change amount of SOC of the battery in the second estimation portion increases.

Seventh Item: A battery full charge capacity estimation program for a battery managed by a battery management system mounted on an electric vehicle, the battery full charge capacity estimation program being configured to cause a computer to realize a storage portion that stores a capacity deterioration model related to preset information of the battery and a capacity deterioration amount of the battery, an acquisition portion that acquires information including a voltage value, a current value, and a temperature value of the battery acquired by sensors, and a first estimation portion that estimates a full charge capacity of the battery, based on the information acquired by the acquisition portion and the capacity deterioration model.

Eighth Item: The battery full charge capacity estimation program according to the seventh item, the battery full charge capacity estimation program being configured to further cause the computer to realize a second estimation portion that estimates the full charge capacity of the battery, based on a discharge current integrated value that is an integrated value of a discharge current of the battery and a change amount of SOC of the battery, and a weighted averaging portion that estimates the full charge capacity of the battery by adding a result obtained by multiplying an estimated value estimated by the first estimation portion by a preset weighting coefficient and a result obtained by multiplying an estimated value estimated by the second estimation portion by a preset weighting coefficient and averaging a result of adding.

Ninth Item: The battery full charge capacity estimation program according to the eighth item, in which the weighted averaging portion increases a weight of the weighting coefficient of the estimated value estimated by the second estimation portion as an absolute value of the change amount of SOC of the battery in the second estimation portion increases.

**Claims**

1. A battery full charge capacity estimation method for a battery (1) managed by a battery management system mounted on an electric vehicle, the battery full charge capacity estimation method comprising:

   an acquisition step (S102) of acquiring preset information (CDt,Ho) of the battery (1); and
   a first estimation step (S104) of estimating a full charge capacity of the battery (1), based on a capacity deterioration model (DM1) in which a relationship between the preset information (CDt,Ho) of the battery (1) and a capacity deterioration amount of the battery is recorded in advance and the preset information (CDt,Ho) of the battery acquired by the acquisition step (S102).

2. The battery full charge capacity estimation method according to claim 1, further comprising:

   a second estimation step (S105) of estimating the full charge capacity of the battery (1), based on a discharge current integrated value ($\Sigma A1$) that is an integrated value of a discharge current of the battery (1) and a change amount of SOC ($\Delta SOC2$) of the battery (1); and
   a weighted averaging step (S106) of estimating the full charge capacity of the battery (1) by adding a result obtained by multiplying the full charge capacity of the battery (1) estimated by the first estimation step (S104) by a preset weighting coefficient (W) and a result obtained by multiplying the full charge capacity of the battery (1) estimated by the second estimation step (S105) by a preset weighting coefficient (W) and averaging a result of adding.

3. The battery full charge capacity estimation method according to claim 2,
   wherein, in the weighted averaging step (S106), a weight of the weighting coefficient (W) of the estimated value (H2) estimated by the second estimation step (S105) is increased as an absolute value of the change amount of SOC ($\Delta SOC2$) of the battery (1) in the second estimation step (S105) increases.

4. A battery full charge capacity estimation device (20) for a battery (1) managed by a battery management system mounted on an electric vehicle, the battery full charge capacity estimation device comprising:

   a sensor (30); and
   a control device (40),
   wherein
   the sensor (30) includes

   a voltage sensor (31),
   a temperature sensor (32), and
   a current sensor (33),

   the control device (40) includes

a storage portion (41) that stores a capacity deterioration model (DM1) related to preset information (ΔSOC1) of the battery (1) and a capacity deterioration amount of the battery (1),

an acquisition portion (42) that acquires information (CDt,Ho) including a voltage value, a current value, a temperature value of the battery (1) acquired by the sensors (30), and

a first estimation portion (46) that estimates a full charge capacity of the battery (1), based on the information (CDt,Ho) acquired by the acquisition portion (42)and the capacity deterioration model (DM1).

5. The battery full charge capacity estimation device (20) according to claim 4, wherein
the control device (40) further includes

a second estimation portion (47) that estimates the full charge capacity of the battery (1), based on a discharge current integrated value (ΣA1) that is an integrated value of a discharge current of the battery (1) and a change amount of SOC (ΔSOC2) of the battery (1), and

a weighted averaging portion (48) that estimates the full charge capacity of the battery (1) by adding a result obtained by multiplying the full charge capacity of the battery (1) estimated by the first estimation portion (46) by a preset weighting coefficient (W) and a result obtained by multiplying the full charge capacity of the battery (1) estimated by the second estimation portion (47) by a preset weighting coefficient (W) and averaging a result of adding.

6. The battery full charge capacity estimation device (20) according to claim 5, wherein
the weighted averaging portion (48) increases a weight of the weighting coefficient (W) of the estimated value (H2) estimated by the second estimation portion (47) as an absolute value of the change amount of SOC (ΔSOC2) of the battery (1) in the second estimation portion (47) increases.

7. A battery full charge capacity estimation program(40a) for a battery (1) managed by a battery management system mounted on an electric vehicle, the battery full charge capacity estimation program being configured to cause a computer to realize:

a storage portion (41) that stores a capacity deterioration model (DM1) related to preset information (ΔSOC1) of the battery (1) and a capacity deterioration amount of the battery (1);

an acquisition portion (42) that acquires information (CDt,Ho) including a voltage value, a current value, and a temperature value of the battery (1) acquired by sensors (30); and

a first estimation portion (46) that estimates a full charge capacity of the battery (1), based on the information (CDt,Ho) acquired by the acquisition portion (42) and the capacity deterioration model (DM1).

8. The battery full charge capacity estimation program (40a) according to claim 7, the battery full charge capacity estimation program being configured to further cause the computer to realize:

a second estimation portion (47) that estimates the full charge capacity of the battery (1), based on a discharge current integrated value (ΣA1) that is an integrated value of a discharge current of the battery (1) and a change amount of SOC (ΔSOC2) of the battery (1); and

a weighted averaging portion (48) that estimates the full charge capacity of the battery (1) by adding a result obtained by multiplying an estimated value estimated by the first estimation portion (46) by a preset weighting coefficient (W) and a result obtained by multiplying an estimated value estimated by the second estimation portion (47) by a preset weighting coefficient (W) and averaging a result of adding.

9. The battery full charge capacity estimation program (40a) according to claim 8,
wherein
the weighted averaging portion (48) increases a weight of the weighting coefficient (W) of the estimated value (H2) estimated by the second estimation portion (47) as an absolute value of the change amount of SOC (ΔSOC2) of the battery (1) in the second estimation portion (47) increases.

FIG.1

FIG.2

FIG.3

FIG.4

FIG.5

S1

| CALCULATION DETERMINATION | RELIABILITY Re | WEIGHTING COEFFICIENT W |
|---|---|---|
| COULD CALCULATE | ≧90% | 1.0 |
| | 80~90% | 0.9 |
| | 70~80% | 0.8 |
| | 60~70% | 0.7 |
| | 50~60% | 0.6 |
| | 40~50% | 0.5 |
| | 30~40% | 0.4 |
| | 20~30% | 0.3 |
| | 10~20% | 0.2 |
| | ≦10% | 0.1 |
| COULD NOT CALCULATE | | 0.0 |

FIG.6

FIG.7A

FIG.7B

FIG.7C

FIG.7D

FIG.7E

FIG.7F

FIG.7G

DM2

TEMPERATURE: T1 [°C]

DT6
DT5
DT4

CAPACITY DETERIORATION RATE [%]

100

LEFT-STANDING TIME

FIG.8

S2

| CALCULATION DETERMINATION | RELIABILITY Re | WEIGHTING COEFFICIENT W |
|---|---|---|
| COULD CALCULATE | ≧50% | 1.0 |
| | <50% | 0.0 |
| COULD NOT CALCULATE | | 0.0 |

FIG.9

Europäisches
Patentamt

European
Patent Office

Office européen
des brevets

# EUROPEAN SEARCH REPORT

**Application Number**

EP 25 17 0881

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/161025 A1 (TOMURA SHUJI [JP] ET AL) 30 June 2011 (2011-06-30) | 1,4,7 | INV. G01R31/367 |
| A | * abstract * <br> * paragraph [0186] - paragraph [0228]; figures 12-25 * | 2,3,5,6, 8,9 | G01R31/3828 <br> G01R31/3842 <br> G01R31/388 <br> G01R31/392 |
|  | ----- |  |  |
| X | US 2024/066993 A1 (KIM YOUNG-MIN [KR] ET AL) 29 February 2024 (2024-02-29) | 1,4,7 |  |
| A | * abstract * <br> * paragraph [0067] - paragraph [0072] * <br> * paragraph [0087] - paragraph [0090]; figures 1-6 * | 2,3,5,6, 8,9 |  |
|  | ----- |  |  |
| X | JP 2016 024148 A (TOYOTA MOTOR CORP) 8 February 2016 (2016-02-08) | 1,4,7 |  |
| A | * the whole document * | 2,3,5,6, 8,9 |  |
|  | ----- |  |  |
| A | US 2009/322283 A1 (ZHANG XIAODONG [US] ET AL) 31 December 2009 (2009-12-31) <br> * abstract * <br> * paragraph [0011] - paragraph [0023]; figures 1-2 * | 1-9 | TECHNICAL FIELDS SEARCHED (IPC) <br><br> G01R |
|  | ----- |  |  |
| A | US 2016/049821 A1 (ARIDOME KOJI [JP]) 18 February 2016 (2016-02-18) <br> * abstract * <br> * paragraph [0028] - paragraph [0121]; figures 1-8 * | 1-9 |  |
|  | ----- |  |  |
| A | US 2015/293183 A1 (TENMYO HIROSHI [JP] ET AL) 15 October 2015 (2015-10-15) <br> * abstract * <br> * paragraph [0014] - paragraph [0058]; figures 1-5 * | 1-9 |  |
|  | ----- |  |  |
|  | -/-- |  |  |

The present search report has been drawn up for all claims

| Place of search | Date of completion of the search | Examiner |
|---|---|---|
| Munich | 26 September 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 25 17 0881

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2015/134282 A1 (SOGA TSUTOMU [JP] ET AL) 14 May 2015 (2015-05-14) * abstract * * paragraph [0022] - paragraph [0089]; figures 1-12 * | 1-9 | |
| A,D | JP 2002 243813 A (NISSAN MOTOR) 28 August 2002 (2002-08-28) * the whole document * | 1-9 | |
| A | JP 2012 108046 A (HONDA MOTOR CO LTD) 7 June 2012 (2012-06-07) * the whole document * | 1-9 | |
| A | US 2018/335479 A1 (HASHIMOTO HIROAKI [JP]) 22 November 2018 (2018-11-22) * abstract * * paragraph [0021] - paragraph [0081]; figures 1-13 * | 1-9 | |
| A | US 2013/311119 A1 (TAMEZANE SHIGETO [JP]) 21 November 2013 (2013-11-21) * abstract * * paragraph [0050] - paragraph [0148]; figures 1-10 * | 1-9 | **TECHNICAL FIELDS SEARCHED (IPC)** |
| A | US 2013/124029 A1 (IZUMI JUNTA [JP]) 16 May 2013 (2013-05-16) * abstract * * paragraph [0029] - paragraph [0097]; figures 1-6 * | 1-9 | |
| A | JP 2014 174050 A (KAYABA INDUSTRY CO LTD) 22 September 2014 (2014-09-22) * the whole document * | 1-9 | |
| A | JP 2012 185124 A (MITSUBISHI HEAVY IND LTD) 27 September 2012 (2012-09-27) * the whole document * | 1-9 | |

The present search report has been drawn up for all claims

| Place of search | Date of completion of the search | Examiner |
|---|---|---|
| Munich | 26 September 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 0881

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2025

| Patent document cited in search report | | Publication date | Patent family member(s) | | Publication date |
|---|---|---|---|---|---|
| US 2011161025 | A1 | 30-06-2011 | CN | 102144169 A | 03-08-2011 |
| | | | EP | 2325664 A1 | 25-05-2011 |
| | | | JP | 4649682 B2 | 16-03-2011 |
| | | | JP | 2010060384 A | 18-03-2010 |
| | | | US | 2011161025 A1 | 30-06-2011 |
| | | | WO | 2010026930 A1 | 11-03-2010 |
| US 2024066993 | A1 | 29-02-2024 | CN | 116583754 A | 11-08-2023 |
| | | | EP | 4253972 A1 | 04-10-2023 |
| | | | ES | 3036385 T3 | 18-09-2025 |
| | | | JP | 7568209 B2 | 16-10-2024 |
| | | | JP | 2023548898 A | 21-11-2023 |
| | | | KR | 20230036929 A | 15-03-2023 |
| | | | US | 2024066993 A1 | 29-02-2024 |
| | | | WO | 2023038398 A1 | 16-03-2023 |
| JP 2016024148 | A | 08-02-2016 | NONE | | |
| US 2009322283 | A1 | 31-12-2009 | CN | 102077105 A | 25-05-2011 |
| | | | DE | 112009001553 T5 | 29-09-2011 |
| | | | US | 2009322283 A1 | 31-12-2009 |
| | | | WO | 2009158226 A2 | 30-12-2009 |
| US 2016049821 | A1 | 18-02-2016 | CN | 105050855 A | 11-11-2015 |
| | | | EP | 2976233 A2 | 27-01-2016 |
| | | | JP | 5812032 B2 | 11-11-2015 |
| | | | JP | 2014185896 A | 02-10-2014 |
| | | | US | 2016049821 A1 | 18-02-2016 |
| | | | WO | 2014147475 A2 | 25-09-2014 |
| US 2015293183 | A1 | 15-10-2015 | JP | WO2014083856 A1 | 05-01-2017 |
| | | | US | 2015293183 A1 | 15-10-2015 |
| | | | WO | 2014083856 A1 | 05-06-2014 |
| US 2015134282 | A1 | 14-05-2015 | CN | 104169733 A | 26-11-2014 |
| | | | EP | 2827164 A1 | 21-01-2015 |
| | | | JP | 6040724 B2 | 07-12-2016 |
| | | | JP | 2013217899 A | 24-10-2013 |
| | | | US | 2015134282 A1 | 14-05-2015 |
| | | | WO | 2013137141 A1 | 19-09-2013 |
| JP 2002243813 | A | 28-08-2002 | NONE | | |
| JP 2012108046 | A | 07-06-2012 | NONE | | |
| US 2018335479 | A1 | 22-11-2018 | CN | 108369257 A | 03-08-2018 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 25 17 0881

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2025

| Patent document cited in search report | Publication date | Patent family member(s) | Publication date |
|---|---|---|---|
| | | EP 3379277 A1 | 26-09-2018 |
| | | JP 6536687 B2 | 03-07-2019 |
| | | JP WO2017085869 A1 | 04-10-2018 |
| | | RU 2690724 C1 | 05-06-2019 |
| | | US 2018335479 A1 | 22-11-2018 |
| | | WO 2017085869 A1 | 26-05-2017 |
| US 2013311119 A1 | 21-11-2013 | JP 5960063 B2 | 02-08-2016 |
| | | JP WO2012105492 A1 | 03-07-2014 |
| | | US 2013311119 A1 | 21-11-2013 |
| | | WO 2012105492 A1 | 09-08-2012 |
| US 2013124029 A1 | 16-05-2013 | CN 103180747 A | 26-06-2013 |
| | | EP 2596375 A2 | 29-05-2013 |
| | | JP 5732766 B2 | 10-06-2015 |
| | | JP 2012029455 A | 09-02-2012 |
| | | US 2013124029 A1 | 16-05-2013 |
| | | WO 2012010955 A2 | 26-01-2012 |
| JP 2014174050 A | 22-09-2014 | NONE | |
| JP 2012185124 A | 27-09-2012 | JP 5535968 B2 | 02-07-2014 |
| | | JP 2012185124 A | 27-09-2012 |

EPO FORM P0459

For more details about this annex : see Official Journal of the European Patent Office, No. 12/82

page 2 of 2

**EP 4 644 927 A1**

**Patent documents cited in the description**

- JP 2002243813 A